# EUROPEAN PATENT APPLICATION

(11) **EP 0 877 257 A2**
(43) Date of publication of application: **11.11.1998**
(21) Application number: 98200163.8
(22) Date of filing: 22.01.1998
(51) Int. Cl.: G01R 1/00

(54) **Electronic unit for measuring electric energy**

(30) Priority: 23.01.1997 IT MI970129
(71) Applicant: TXT S.p.A., 20128 Milano (IT)
(72) Inventor: Braga Illa, Alvise, 20123 Milano (IT); Cicognani, Luca, 21052 Busto Arsizio (VA) (IT); Crespi Reghizzi, Stefano, 20121 Milano (IT); De Bellis, Antonio, 20139 Milano (IT)
(74) Representative: Giavarini, Francesco

(57) **Abstract**

Electronic unit for measuring electric energy supplied by a producer to a user, comprising sensors (of the current and/or voltage and/or power and/or rotational or other type) located directly or indirectly on the power supply line and an electronic unit for processing the signal provided by said sensors, said unit comprising at least one database and at least one programmable microprocessor. According to the invention, the program which runs on said microprocessor is organized as a set of algorithm agents, including at least one "agenda" algorithm agent and at least one "function" algorithm agent (for each of the functions: measurement, processing, communication); said algorithm agents operate independently as concurrent processes; and said algorithm agents interact only by means of remote procedure calls, without sharing data.

## Description

The present invention relates to an electronic unit for measuring electric energy, commonly called "meter", of the type used by electricity supply companies for calculating basically the quantity of electric energy supplied to a given user application, from which a corresponding cost to be debited to the user is obtained, i.e. single/multiple hourly tariff calculation.

The traditional measuring units, used for some time in alternating-current supply systems, are based on a current sensor with a disc rotating owing to an induction effect, Galileo Ferraris type, the speed of rotation of which is proportional to the instantaneous active power and the number of revolutions of which is therefore proportional to the power supplied. The disc actuates, by means of a special drive system, a number indicator, the digits of which thus indicate directly the power supplied.

More recently measuring units of the electronic type have been proposed, i.e. in which, downstream of the sensor part - whether it be of the conventional type with an induction-rotating disc or of the type which is in turn electronic - there is located a microprocessor unit which processes the measurements collected by the sensor part and, depending mainly on the time, provides a series of parameters useful for calculating the cost of the electric energy to be debited, in accordance with a tariff which takes into account various variables.

In Italy, as of 1984, the company ENEL - Ente Nazionale per l'Energia Elettrica - began using hybrid meters, i.e. having a microprocessor unit associated with a sensor consisting of an induction-rotating disc for medium and high-voltage uses. At the start of the Nineties a project was launched for the production of a series of new hybrid meters, to be installed at any mains user application, including low-voltage ones. The performances of the electronic units in this series, generally called EUs, are described in the ENEL specification documentation (SISTEMA DI TELEGESTIONE [TELEMANAGEMENT SYSTEM]: in particular Tab. ENEL DH023 Unità di Elaborazione periferica UEP per GMY e GTY [UEP peripheral Processing Unit for single GMY and GTY] Ed. II, September 1992, Tab. ENEL DH026 Unità di Elaborazione periferica UEPM per GTWM [UEPM peripheral Processing Unit for GTWM] Ed. II June 1990, Tab. ENEL DH025 Unità di Elaborazione periferica UEPB per GTWS e GTWD [UEPB peripheral Processing Unit for GTWS and GTWD], Ed. II, February 1993; for a general description of this TELEMANAGMENT SYSTEM, reference should be made to the article: E. Comellini ENEL-DDI "Il nuovo sistema dell'ENEL per il telecontrollo della rete e la telegestione dell'utenza" ["The new ENEL system for telecontrol of the network and telemanagement of user applications"] L'ELETTROTECNICA VOL LXXVIII No. 11, November 1991) and basically comprise the functions of:
- measuring and calculating the technical parameters useful for determining the tariffs for electric energy: active and reactive, consumed and supplied energy, in various time bands; medium power, over different time periods;
- memorizing the parameters thus calculated, associating them with the time references required by the regulations in connection with the calculation of tariffs for electric energy and retaining them in the memory for subsequent reading;
- eliminating the disturbances existing on the electricity networks, avoiding contamination of the tariff data and measurements by electrical or mechanical noise, e.g. spurious oscillations of the Ferraris disc;
- managing the communication channels: to any displays and/or keyboards of the unit; to auxiliary equipment, such as instruments for testing, programming, initialization, and reading of data; to communication modems of various types, "power line carrier" type which use the electricity network as a communications medium, optical IEC 1107; etc..

The EU's have hitherto been realized by means of a microprocessor board programmed using conventional techniques, i.e. by means of the assembler language typical of the microprocessor used in each case, also using in some cases a operating system kernel for management of the microprocessor hardware resources.

This programming method suffers from at least the following main drawbacks:
a) rigidity of the system on account of the difficulties of updating and/or modifying the software, when this is necessary for example for adaptation to modified tariff conditions;
b) impossibility, or at least considerable difficulty, of transferring the software from one microprocessor to another, where this becomes necessary, for example, owing to the fact that the currently used microprocessor has become obsolete, with consequent high costs;
c) too close an interlinking between the functions performed by the various parts of the program, subprograms or branches selected by conditional instructions, and consequent difficulties in testing the system following functional modifications requested;
d) difficulty or impossibility in operating the apparatus in a partial or reduced manner, inhibiting some of the functions performed by it.

Even when the microprocessor is programmed by means of other languages of a higher level than the assembler, for example in C, the various functions of the electronic measuring unit are carried out as subroutines or by means of branches of the main program selected by control instructions, so that the same drawbacks a), c) and d) mentioned above remain.

The object of the present invention is to propose an electronic unit for measuring electric energy which overcomes these drawbacks and offers moreover further advantages.

This result is achieved by means of the characteristics mentioned in the claims.

The invention is therefore characterized by the use of an "algorithm agent" for each of the specific functions of the electronic measuring unit. Each algorithm agent is synchronized and communicates with the other algorithm agents, making use of remote procedure calls, RPC, or procedure execution requests made available by the algorithm agent called to carry out a service for the calling algorithm agent in respect of the data otherwise invisible to the latter.

By the term "algorithm agent" is understood hereinbelow a program, or an independent program block consisting of one or more processes, or tasks, involving calculation or response to the microprocessor interrupts, able to operate concurrently with other algorithm agents. The functions performed by an algorithm agent are protected or incorporated inside it and are independent of the others performed by other algorithm agents.

Each algorithm agent consists of the following component elements:
- the internal status, or a structure of data suitable for representing the information useful for the algorithm agent itself;
- a set of remote procedures, also called methods or entries, made available to the other algorithm agents;
- a set of procedures, also called drivers, for responding to certain interrupt signals;
- a main program, i.e. the one in which the agent starts to operate when it is initialized.

The internal status of the algorithm agent - described in greater details hereafter, is protected from any action performed by different agents and can be read or modified only by the methods, drivers, or main program belonging to the same algorithm agent. The algorithm agents incorporate inside them in an automatic and trasparent manner one or more concurrent processes, among the others those realizing the processes for handling interrupts, i.e. drivers.
Interrupts are generated by internal or external events to the measuring EU and allow to manage events which are asynchronous to normal operational flow, e.g. communication with an external device, clock pulse, etc..
Encapsulation of different processes inside an algorithm agent allows the design engineer to digress from management inherent to the operating system and concentrate on the application, to the benefit of the reliability and quality of the final software program.

The activations of the functions of a temporal nature, such as starting and/or cessation of a programming operation, closing of an invoicing period, etc., are co-ordinated by a main algorithm agent, referred to below as "agenda", the details of which are given further below. The other functions are performed separately in subordinated algorithm agents, referred to below as "function" agents, the details of which are also indicated further below.

It is in fact already known that when, as a support for application programs, use is made of an operating system kernel for management of the hardware resources of the microprocessor, the functions of the electronic measuring unit are performed by incorporating them inside concurrent processes or tasks. In this case, however, a concurrent process is characterized by its own execution context, e.g. working register, microprocessor, support memory area or stack, etc., saving and restoration of which is assigned to the operating system; the operating system moreover makes available procedures which allow the processes to be synchronized and communicate with one another. Consequently, the concurrent processes are necessarily performed by the same microprocessor and intercommunicate, reading and writing data into certain memory areas shared between the processes: there therefore exists a close dependency between the software provided and the hardware platform used. Therefore all the drawbacks mentioned above remain, albeit to a lesser degree.

Further characteristic features and advantages of the device according to the present invention will emerge more clearly, however, from the detailed description which follows of a preferred embodiment thereof, provided by way of an example and with reference to the accompanying drawings, in which:
Fig. 1 shows a general diagram of an algorithm agent;
Fig. 2 shows the diagram of the structure of an agenda algorithm agent;
Fig. 3 shows the diagram of the structure of a function algorithm agent for the measuring function;
Fig. 4 shows the diagram of the structure of a function algorithm agent for the processing function;
Fig. 5 shows the diagram of the structure of a function algorithm agent for the communication function; and
Fig. 6 shows the diagram of the structure of a function algorithm agent for the carrier function.

As already mentioned the main functions which the electronic measuring unit according to the present invention is able to perform are those of:
- measuring and calculating the technical parameters useful for determining the tariffs of electric energy, active and reactive, consumed and supplied energy, in various time bands; medium power, over different time periods;
- memorizing the parameters thus calculated, associating them with the time references required by the regulations of each country in connection with calculation of the tariffs for electric energy and retaining them in the memory for subsequent reading;
- eliminating the disturbances existing on the electricity networks, avoiding contamination of the tariff data and measurements by electrical or mechanical noise (spurious oscillations of the Ferraris disc);
- managing the communication channels: to any displays and/or keyboards of the unit; to auxiliary equipment, such as instruments for testing, programming, initialization, and reading of data; to communication modems of various types, e.g."power line carrier" type which use the electricity network as a communications medium; telephone type; radio wave.

In order to perform the functions described it is also necessary for the following basic tasks to be carried out:
1) management of the clock/calendar function;
2) management of a tariff program, designed to allow the application of varying tariffs in accordance with the existing regulations, with the possibility of daily and seasonal modulation;
3) counting of the energy units measured by the Ferraris hybrid meter or by the measurement module directly in terms of electrical parameters, for the electronic meter;
4) processing of the energy units in order to divide up the energy consumed by the user in accordance with the tariff program which is currently applicable and determining the average power values;
5) processing information useful for determining the quality of the service and any attempted fraudulent action;
6) management of the procedures for configuration and initialization of the operating parameters;
7) management of the procedures for communication with other apparatus;
8) management of the command for opening the thermomagnetic switch where present;
9) management of the emergency following the event "power supply interruption" in order to guarantee in any case the consistency of the tariff information acquired up to occurrence of the event.

The information acquired and to be processed for tariff purposes forms in its entirety a database of the electronic measuring unit and consists fundamentally of the following:
- invoicing data: this indicates the energy consumed and the power used, divided up according to tariff type and relating to the relevant invoicing period for the existing regulations, for example: current period, period preceding the current one, etc.;
- parameters for identification of the electronic measuring unit: these show the rating-plate data of the electronic measuring unit, as well as all the other information useful and necessary for management thereof, in accordance with the prescribed procedures;
- time parameters: these consist essentially of a clock and/or calendar, with all the information of an auxiliary nature which is considered essential for carrying out the task, for example: calculation of the day of the week, management of summer-time, etc.;
- parameters identifying the supply contract: these indicate the information relating to the user and the type of contract drawn up in terms of the power used per individual tariff, disconnection privileges, invoicing procedures, etc.;
- tariff programming parameter: these provide, in accordance with programming on a daily, weekly, seasonal and/annual basis, an indication of the tariff to be applied at each moment during the day.

For the management of all this information, according to a main characteristic feature of the invention, programming is performed by means of mechanisms, conventionally called "algorithm agents" which can be coded in a programming language.

According to a preferred embodiment, a way of providing an algorithm agent is to use a programming language capable of expressing the presence of concurrent activities. The theoretical model on which the algorithm agents are based is that of Brinch-Hansen's distributed processes ("Distributed processes: a concurrent programming concept", Communications ACM, 21, 11, pp 934-941, 1978). The most well known concurrent-process languages include ADA ("Ada 95 reference manual", ANSI Standard 1995), the task, entry and protected object concepts of which have similarities with the abovementioned concepts for the algorithm agents. However, ADA is a language intended for information-technology applications of far greater hardware dimensions and resources such as military control and command systems; its use for electronic measuring devices would be unfeasible from a cost point of view. A valid alternative consists, in accordance with that proposed by the present invention, of the language MML/MME (Boari M., Crespi-Reghizzi S., Dapra' A., and Natali A., "Multiple-processor programming techniques: MML a new set of tools", IEEE Computer Magazine, Jan. 1984, pp 47-56), a concurrent-process language especially designed for the realization of small real-time systems, with an architecture composed of one or more microprocessors.

Alternatively, the algorithm agents may also be realized by combining a sequential programming language, i.e. without concepts necessary for describing parallel or concurrent activities, such as, for example, assembler or C, with a system support for carrying out concurrent processes. In the case of an architecture with several processors, the system support must also manage a distributed program. This system support is not limited to the activities performed by an operating system kernel, because it must ensure all necessary controls for correct functioning of the various activities of the algorithm agent.

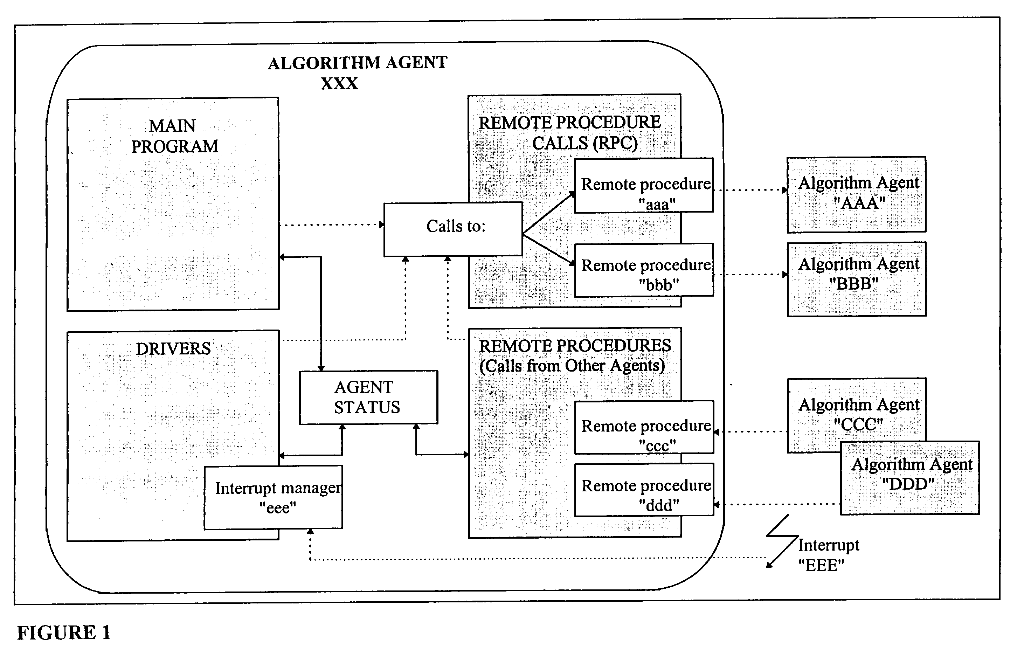

According to the present invention, and as already mentioned, the algorithm agents of the measuring EU are essentially divided in two groups: a main algorithm agent, called 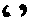 agenda 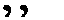 , acting as coordinator, as hereafter explained, and various 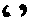 function algorithm agents. In the following examples of istances of algorithm agents are given for the actuation of the invention, referring to the general diagram, shown in figure 1, with reference to which the following must be noted:
a) In the schematic illustrations of the main algorithm agents of the electronic unit for measuring electric energy not all the elements shown in Figure 1, main program, drivers, remote procedure calls, remote procedures, will be necessarily present. The presence is represented by the corresponding grey-coloured box; the absence by the white-coloured box with broken external lines.
b) the main program may be of two types:
   - active: processing is performed cyclically; any suspension occurs indirectly on account of the arrival of an interrupt to be served or directly for carrying out a suspend instruction on a signalling system, these being reactivated by a remote procedure (RP) or a driver, or for carrying out a suspend instruction for a certain time period (delay expiry wait); this is represented by a circle interrupted by an arrow;
   - passive: processing is not of the cyclical type and has a time-limit. When this time-limit is reached, it is no longer performed except in the case of restart of the entire software; this is represented by the absence of a symbol.
c) the management of an interrupt by a driver may be compared to calling up of a remote procedure (RP) by the hardware level of the machine.

In particular:

### A) "Agenda" algorithm agent

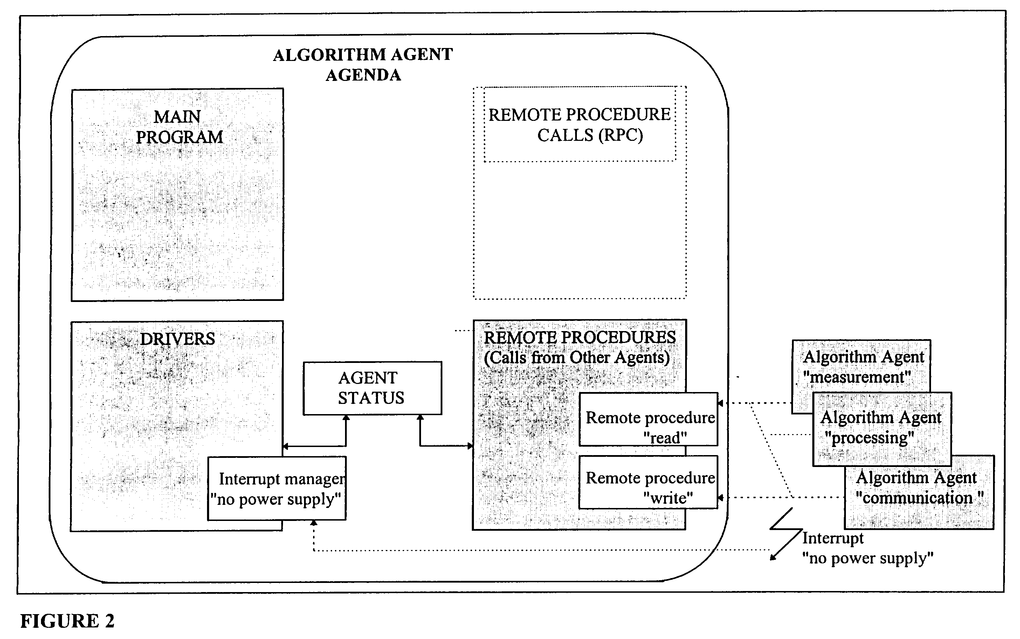

Figure 2 shows the structure of the "agenda" algorithm agent and in particular the main components and their interaction.

This agenda agent essentially contains the database of the electronic measuring unit, structured in accordance with the concept of stable memory.

According to this concept, the information is structured and grouped together in logic blocks, each of which is terminated by a checksum. During the operations involving reading and writing of these blocks, the checksum is respectively verified and updated so as to have an indication regarding the consistency of the data contained therein. In order to ensure protection against possible corruptions, at least one copy of the database is created, so that the transitory disturbances which have corrupted the information in a block are recovered from the uncorrupted copy. If all the copies should be inconsistent, a recovery procedure which differs according to the type of block, e.g simple resetting of the contents, freezing of the corrupted information, etc., is activated.

In order to guarantee the consistency of the database in addition to the presence of the mechanisms described above, the procedure for updating the contents of the database is performed in a transactional, or atomic, manner, i.e. guaranteeing complete saving of the updating being performed, also following an interruption in the power supply.

Access to the database takes place with mutual exclusion between the various algorithm agents and is governed by means of the sole use of the remote procedures made available by the "agenda" algorithm agent.

The main procedures available allow:
- reading of one or more blocks of the database - "read"
- updating of one or more blocks of the database - "write"

The procedure with which the copies of the block are executed and managed is completely transparent to the various algorithm agents which carry out the calls for the available access procedures.

Since the realization aspects are confined within the "agenda" algorithm agent, it is possible to adapt them to the actual applicational specifications and to the physical memorization media available, leaving unaltered the management of the other algorithm agents.

In particular, it is possible to envisage, should it be required, the possibility of introducing an "in use" indicator for those blocks which are removed by an algorithm agent and which will be updated by the latter, so that other algorithm agents which require the same block for further updates remain in a waiting condition until the blocking agent has terminated.

The "agenda" algorithm agent at the start of the application carries out:
1) restoration of the database, recovering the information and the data from the static memorization devices (these consist of those memory devices which ensure that the contents of the memory cells are retained even when there is no power supply: for example EEPROM, NOVRAM, etc.) and their duplication onto dynamic memorization devices (these consist of those memory devices which lose the contents of the memory cells when there is no power supply: for example, an unbuffered RAM);
2) analysis of the contents of the database, in order to determine the consistency and establish the operating status of the electronic measuring unit;
3) processing of the contents of the database in order to generate the agenda of the activities which the other algorithm agents will have to perform.

The "agenda" algorithm agent is provided internally with a driver for managing the interrupt which is produced when the minimum threshold of the supply voltage is exceeded (management of the no power or power failure interrupt).

Here it must be pointed out that, in the arrangement of the algorithm agents according to the invention, no recourse is made to use of the non-maskable interrupt NMI, but this event is managed using a maskable-type interrupt associated with the driver component of the "agenda" algorithm agent.

This choice allows one to use the mutual exclusion execution mechanisms inherent in the components of an algorithm agent, helping ensure in this case the consistency of the database in any circumstances. In fact, even if the interruption in power supply were to occur during a database updating operation, this operation would be concluded before passing over to execute the driver (transactional or atomic nature of access to the database).

By setting the hardware priority of this interrupt so that it is higher than any other interrupt and taking into account the fact that the drivers have a higher priority than any other component of an algorithm agent, setting the voltage alarm threshold to a level such that it leaves a margin of at least 100-200 ms, this event may be managed in a more reliable manner, without making use of the non-maskable interrupt which has the drawback that it interferes, in a manner which is difficult to predict, with the active process at the moment of the voltage drop.

The power failure driver, when activated, produces the following actions:
1) disables any other interrupt source, so as to prevent interruptions during execution of the saving actions undertaken following de-energization;
2) resets any pending interrupt service requests, again in order to prevent interruptions during the execution of saving operations undertaken following de-energization;
3) deactivates all the hardware devices which are not indispensable so as to drastically reduce consumption;
4) recovers the information from the dynamic media of the memory and suitably memorizes it in the static media.

The "agenda" algorithm agent takes its name from the fact that it manages an agenda which contains all the activities which the other algorithm agents must perform, in particular as regards the activities assigned to the "processing" algorithm agent. This organization is based on the theoretical parallel calculation model (Carriero N. and Gelernter D. "How to write parallel programs: a guide to the perplexed", ACM Computing Survey, 21, 3, Sept. 1989), called "agenda" type.

In fact, both at start-up of the application and following memorization in the database of new programming operations received, for example, future supply contract, expiry of invoicing period, tariff program, etc., the "agenda" algorithm agent prepares an agenda which indicates the actions to be performed. This agenda is structured in accordance with the needs and specific requirements of the tariff regulations applicable for the electronic measuring unit. Assuming that the tariff change may occur exclusively after lapsing of half an hour, it is of significance to be able to verify the need for performing this change at such a time-limit. If the consumption is invoiced on a monthly basis, it is of significance to verify the time-limit at the end of each month.

It is entirely the responsibility of the "agenda" algorithm agent to keep updated the time-limit schedule for the actions to be performed. Moreover, it must also propose to the other algorithm agents the list of activities which are still to be performed and have not yet been concluded, for example: closing the current invoicing period after a power failure period during which a request was made to perform this activity.

Although forming part of the database of the electronic measuring unit, the blocks forming the "agenda" algorithm agent are not saved in the static memory devices, but are kept exclusively in the dynamic memory devices. Therefore, this "agenda" is lost following a power failure; however, since all the programming operations are memorized in the static devices, the contents of the "agenda" may be recovered and regenerated upon restarting of the application. The decision to make the "agenda" algorithm agent volatile essentially allows the size of the static devices required to be reduced, the latter being more expensive than the dynamic ones. Where it is required or possible, however, it is certainly conceivable to also use the static medium.

The main function agents are the following:

### B) "Measurement" algorithm agent

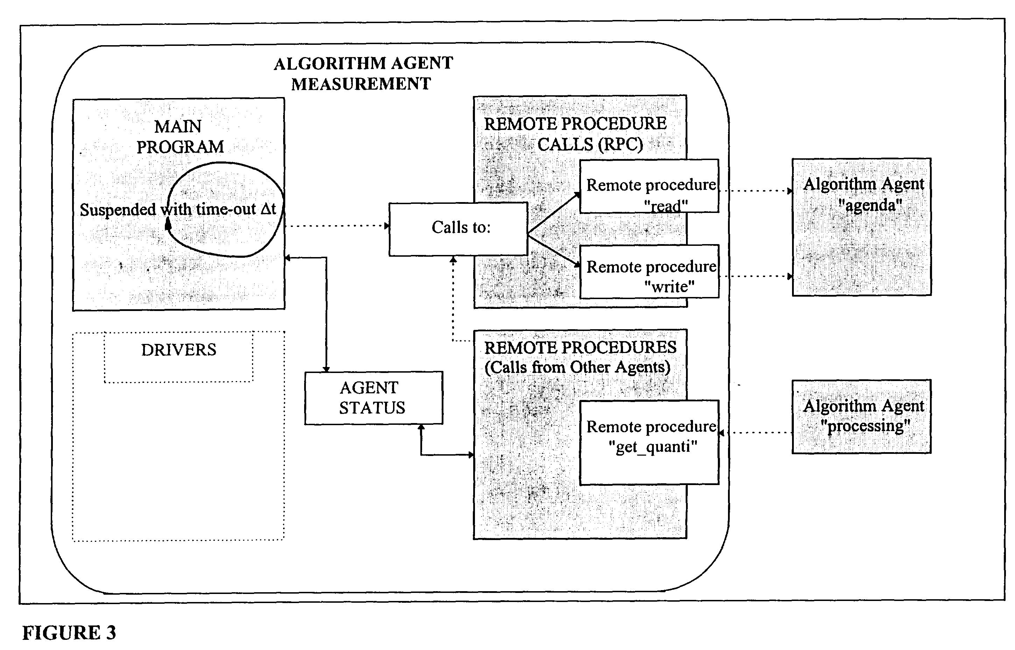

Figure 3 shows the structure of the "measurement" algorithm agent, and in particular the main components and their interaction.

The "measurement" agent carries out the function for calculation of the "energy units". Typically it is a periodic activity with a fairly high operating frequency compared to that of other algorithm agents, for example: every 100 ms for hybrid meters. The data updated in the database of the electronic measuring unit by this algorithm agent consists in the energy units arising at each reactivation, which are incrementally added in a register, referred to below as "wait register".

So as to allow the "processing" algorithm agent (see below) to process the information relating to the acquired energy units, without this blocking the "measurement" algorithm agent, a remote procedure "get_units" is made available, having the function of copying the value of the wait register containing the energy units into another register, referred to below as "processing register" for exclusive use of the "processing" agent and subsequently resetting the contents of the wait register. Taking into account the fact that the remote procedure "get_units" requires access to the database via the "read" and "write" RPC and that, inside the "measurement" algorithm agent, execution between the main program and the remote procedure "get_units" occurs with mutual exclusion, this guarantees synchronism between the activities performed by the two "measurement" and "processing" algorithm agents, with automatic suspension while waiting to perform the operation requested if the other activity is in progress.

The "measurement" algorithm agent is also responsible for providing the necessary filters for protection against disturbances of an electrical and/or mechanical nature which may invalidate the "measurement".

The characteristics of the "energy units" depend on the type of sensor system used for detecting the consumption. In the case of the hybrid meter the problem is limited to detection of rotation of disc owing to the induction effect and to counting of the segments which identify a certain predefined measurement of energy consumed by the user. In the case of the completely electronic meter, depending on the type of sensor used, e.g. Hall effect, transformers, shunts, custom or semi-custom circuit, etc. it is possible to obtain fundamental or derived electrical parameters associated with the real consumption of the user, from which the measurements of interest from a tariff point of view may be obtained directly or by means of suitable processing. In this latter case, the possible spectrum of alternatives to be associated with the "energy units" concepts is therefore wide-ranging.

In the present description below, the term "sensor" therefore indicates any one or a combination of the elements referred to above.

### C) "Processing" algorithm agent

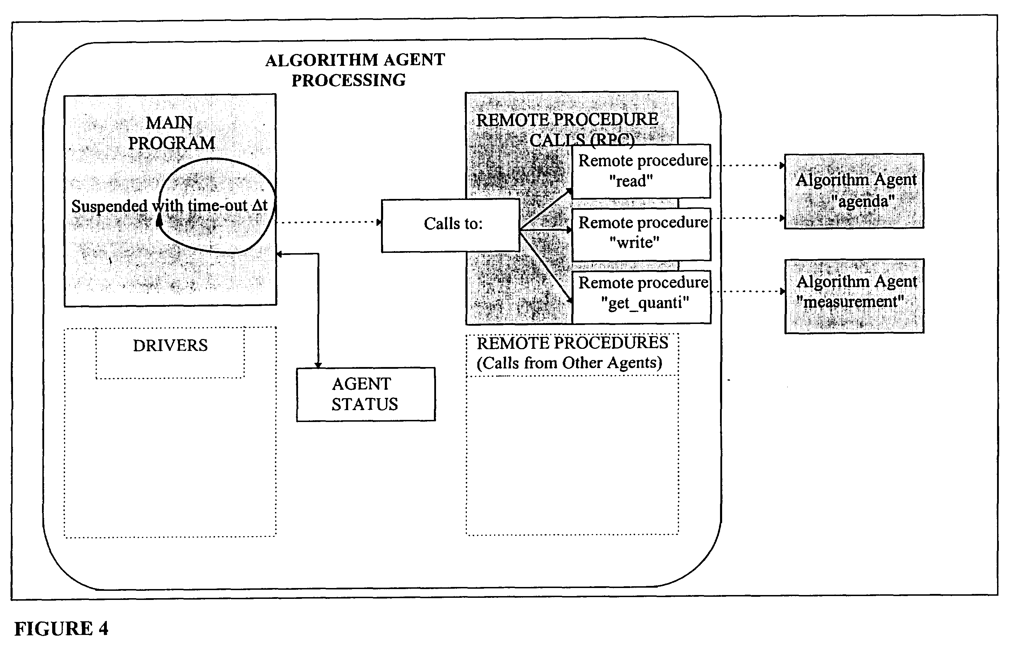

Figure 4 shows the structure of the "processing" algorithm agent and in particular the main components and their interaction.

The "processing" agent is responsible for performing processing of the units and the information required for tariff-calculation.

In particular the activities which are to be actually performed are determined by the "agenda" algorithm agent.

On the basis of the units updated by the "measurement" agent in the database of the electronic measuring unit, the "processing" agent updates the tariff data relating to the energy and power for the current tariff. Moreover, on the basis of the information provided by the "agenda" agent, it carries out and renders operative the programming operations previously configured at the database level.

### D) "Communication" algorithm agent

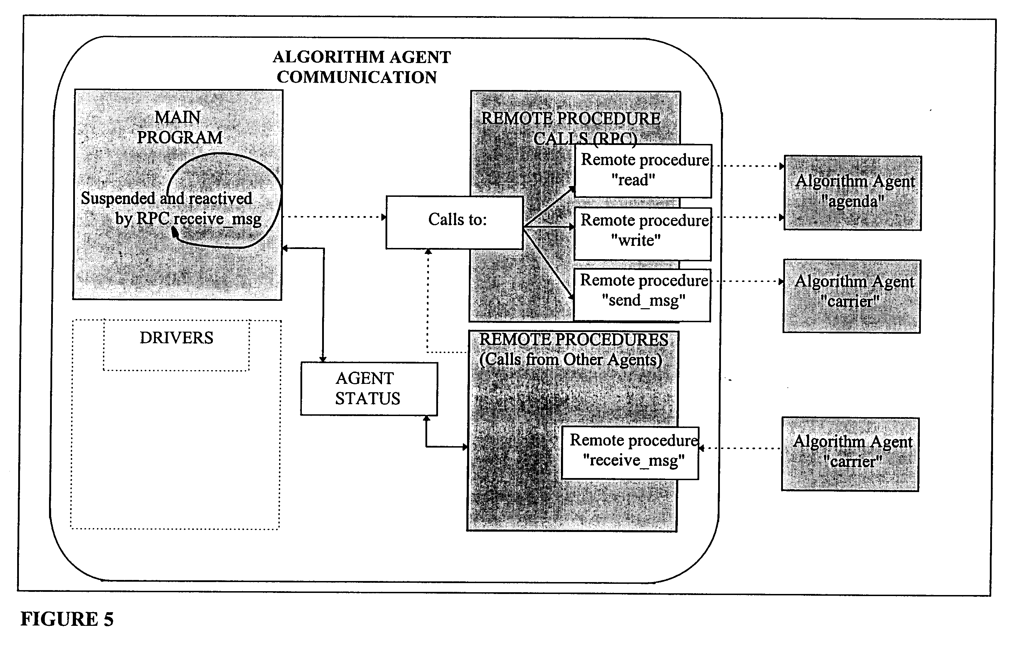

Figure 5 shows the structure of the "communication" algorithm agent and in particular the main components and their interaction.

The "communication" algorithm agent assumes responsibility for managing communication with the remote devices which dialogue with the electronic measuring units with the aim of programming the operating parameters, reading the amounts consumed, etc.

In practice this algorithm agent is the manager of the application messages exchanged by the electronic measuring unit and is responsible for access to the information of the database in accordance with the instructions and the actions requested by each message. The messages managed at this level are independent of the physical communication protocol, the details of which are the responsibility of the "carrier" algorithm agent (see below).

Should the specifications require more than one communication carrier, each characterized by its own physical protocol, it is possible to assign to the "carrier" algorithm agent the task of normalization of the messages originating from and directed to different sources. Normalization thus allows one to have only one manager.

### E) "Carrier" algorithm agent

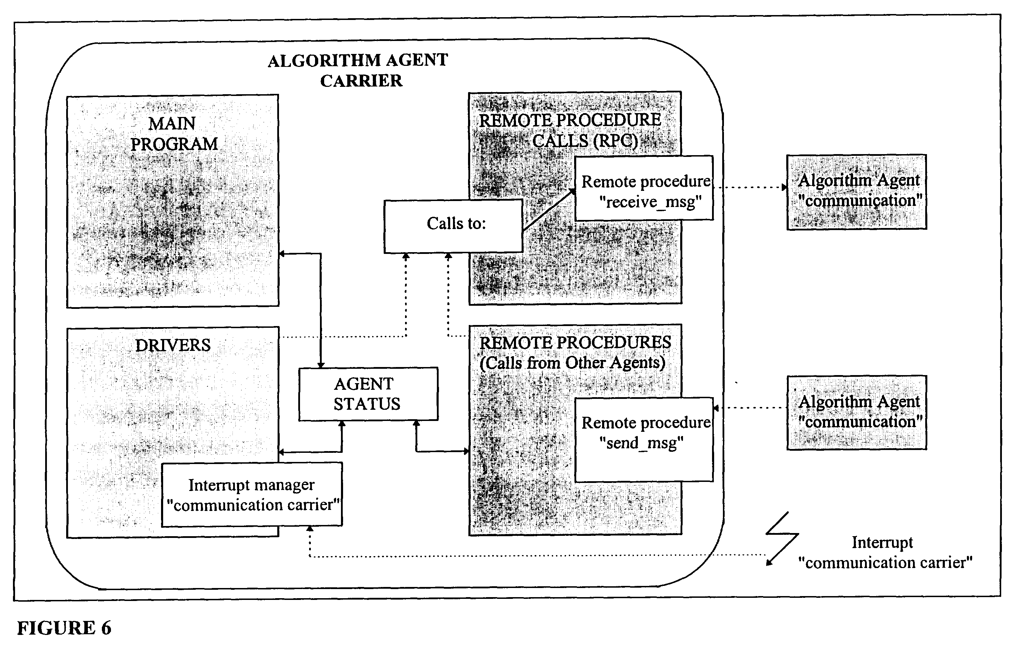

Figure 6 shows the structure of the "carrier" algorithm agent and in particular the main components and their interaction.

The "carrier" agent is responsible for management of the communication device and the stages of processing of the message control information (for example: address, start and end field, message length, checksum, etc.) received at the input and of any associated responses.

The messages, after elimination of the control information, contain the data information of the applications protocol (the "user data") which are processed by the "communication" algorithm agent.

If required, the "carrier" algorithm agent performs an operation of normalization/denormalization of the application messages in transit so that there is a single communication manager provided by the "communication" algorithm agent.

### F) Other function algorithm agents

In addition to the algorithm agents described above it is possible, where required, to envisage further algorithm agents, with additional functions, for example:
- a "diagnostics" algorithm agent
- a "display" or "keyboard" algorithm agent
- a "load manager" algorithm agent,
the functions of which may be summarised as follows.

The "diagnostics" agent is a low-priority algorithm agent which is operative when all the other algorithm agents are at rest and is responsible for verifying the hardware and software resources available, signalling any malfunctions. Depending on the malfunction conditions and the resources actually available, it ensures as far as possible that the application may be executed, ensuring minimum operation. In particular, it signals which other algorithm agent has not been executed correctly. With the algorithm agent organization according to the invention it is intrinsically easier and less onerous to introduce excess values for a more efficient fault-tolerance policy.

The "display" and "keyboard" agents perform management of any devices for local interaction with the user, i.e. consisting of a display and a keyboard, in accordance with the requirements stipulated in the specification of the electronic measuring unit. By means of the display the information relating to consumption as well as all those situations which compromise the electric supply in the short term (arrears, maintenance work on the network, etc.) is displayed. The keyboard allows the user to select the information of interest.

The algorithm agent "load manager" enables a check to be carried out on user loads, allowing, where required, precautionary action to be taken with regard to power excesses, thus avoiding the payment of penalties where envisaged.

According to the present invention it is obviously possible that the algorithm agents described in the preceding points A) to F) may in some applications in turn each be formed as a set of other algorithm agents and, conversely, it is possible to concentrate the functions performed by different algorithm agents in a single agent. It is possible to mention, for example, the case of the "carrier" algorithm element, where several communication lines are provided. In this case it is conceivable for there to be a greater number of agents of the "carrier" type, each of which manages the physical communication interface assigned to it. As regards the possible concentration, mention may be made of the case where, for those applications where the exchanged messages are few and extremely simple, it is decided to make processing of the control information indistinguishable from information of an applicational nature. In this case the two agents "communication" and "carrier" would merge into one only.

In general, within the scope of this invention, it is considered that there must necessarily exist an "agenda" algorithm agent and at least one function algorithm agent. The complexity and any subdivision of the latter into further agents is dependent upon the nature of the application specifications and on the right compromise between the choice of reducing the number of agents, in order to simplify the application, and that of increasing it, in order to separate and isolate better the individual functions.

It is important to note that in the electronic measuring unit according to the invention, where the possibility of updating the application code without replacing the memory component is required, there exists a program loading software ("bootloader") intrinsically separate from the application code and to all intents and purposes forming an autonomous application. This software may be realized by means of an algorithm agent. In the EU's mentioned in the introduction, however, there is not a clear separation between the two and code parts, for example, the procedures for management of the communication hardware, the procedures for management of the physical and application protocol, etc., are shared. This results in the provision of non-linear management solutions, to the detriment of the reliability and the ease of maintenance.

Thus, in the measuring units according to the invention, the production hardware testing procedures may be always activated, without having to cancel the application code. This availability allows the causes of malfunctions to be rapidly identified and allows the Electricity Corporation supplying the energy to collect statistical data on the causes of the malfunction affecting its meter park.

As regards the hardware construction, the invention is suitable for being implemented in such a way that:
- each algorithm agent uses a separate microprocessor, thus realizing a distributed or parallel system, namely,
- all the algorithm agents use the same microprocessor and a single database, all the agents, however, remaining strictly separate from one another, as will be explained in more detail below.

In the case where a single microprocessor is used, the difference in hardware compared to the traditional solutions tends to disappear. The choice of hardware construction is determined exclusively by considerations relating to the cost of the electronic components or reliability of the system; all the possible hardware implementations (one microprocessor for each agent, or one microprocessor for all the agents, as well as all the other possible solutions between these extremes) remain within the scope of the present invention.

Obviously, it is also possible to use integrated custom or semi-custom components, designed to perform at least some of the functions carried out by one or more algorithm agents, for example, the measuring module for calculation of the electrical parameters, the carrier module specialized for management of the physical communication protocol on power line carriers, etc..

To conclude, the measuring units according to the invention, obtained with the innovative techniques described, have the following advantages compared to those realized with traditional techniques:
1. Greater operating safety
   In fact, malfunctioning of a function performed by a function algorithm agent does not adversely affect regular operation of the other algorithm agents. The data is protected from anomalous behaviour during switching on and switching off.
2. Ease of updating and modifying the functional activities
   The intrinsic functional separation, which is obtained thanks to the use of algorithm agents, allows the software to be updated and modified without the risk of introducing malfunctions in other parts of the program. For the same reliability of the modified software, the cost of the modifications is by far less in the units according to the invention compared to the similar cost in the EU's mentioned. In the latter, the cost and the quality of the modifications are very much linked to the skill of the programmer and his/her knowledge of the system to be modified. In the case of the units according to the invention, the quality of the original code and that of the modified code are little influenced by the skill of the programmer.
   This feature of the units according to the invention is very important since the expected life of the meters is more than twenty years. Over such a long time period it is practically certain that there will be new tariff-related and operational requirements involving variations in the original code and that the original programmers will no longer be available.
3. Ease of transferring the software to different microprocessors.
   The software of the measuring units according to the invention can be transferred easily, and hence at little cost, from one microprocessor to another. New microprocessors are introduced onto the market by international manufacturers every two to three years and at the same time the preceding microprocessors become obsolete or more costly to maintain. The invention therefore allows the hardware to be modified without modifying the application software, i.e. the individual algorithm agents. This ease of transfer, in addition to a reduction in the costs of manufacture of new meters, allows the Electricity Corporations supplying the energy to update their hardware park, re-utilizing a software application which is already tried-and-tested as regards the functional aspect. In this way the maintenance costs are drastically reduced, increasing at the same time the reliability and quality of the service provided to the end user.

It is understood, however, that the invention must not be considered as being limited to the particular embodiment described above, but that numerous variations different therefrom and within the scope of a person skilled in the art may be made without thereby departing from the protective scope of the invention itself, as defined by the claims which follow. In particular, it is understood that the present invention includes embodiments in which the functions of the algorithm agents described are combined in plurifunctional agents or, vice versa, distributed among several specialized agents. It is obvious, moreover, that the invention described above is applicable both to completely electronic meters as well as to "hybrid" meters in which, as mentioned, the measuring sensor is of the traditional type, i.e.Galileo Ferraris with induction-rotating disc.

## Claims

1. Electronic unit for measuring electric energy supplied by a producer to a user, comprising sensors of the current and/or voltage and/or power and/or rotational or other type located directly or indirectly on the power supply line and an electronic unit for processing the signal provided by said sensors, said unit comprising at least one database and at least one programmable microprocessor, characterized in that:
- the program which runs on said microprocessor is organized as a set of algorithm agents, including at least one "agenda" algorithm agent and at least one "function" algorithm agent;
- said algorithm agents operate independently as concurrent processes;
- said algorithm agents interact only by means of remote procedure calls, without sharing data.

2. Electronic unit for measuring electric energy as claimed in Claim 1, comprising at least one function algorithm agent for each of the functions: measurement, processing and communication.

3. Electronic unit for measuring electric energy as claimed in Claim 1, wherein each of the function algorithm agents is co-ordinated and synchronized by the "agenda" algorithm agent.

4. Electronic unit for measuring electric energy as claimed in Claim 1, wherein the "agenda" algorithm agent makes available remote procedure functions for memorizing in the database of the electronic measuring unit the results of its processing and for fetching from the database the data which are of relevance for it.

5. Electronic unit for measuring electric energy as claimed in Claim 4, wherein the "agenda" algorithm agent provides the stable memory which contains said database by providing, in an automatic and transparent manner for the functions, the mechanisms for management of the physical devices for memorization of the database, for structuring and duplication of the database and for recovery of the data so as to guarantee the consistency and reliability thereof under any circumstances.

6. Electronic unit for measuring electric energy as claimed in Claim 1, wherein the "agenda" algorithm agent manages the procedure for updating the contents of the database on the static memorizing devices in an atomicmanner, guaranteeing complete saving of the last updates performed on the database in any circumstances, even following an interruption in the power supply.

7. Electronic unit for measuring electric energy as claimed in Claim 1, wherein the "agenda" algorithm agent, at the start of the application, carries out the following activities:
- restores the database, recovering the information and the data from the static memorization devices, and performs duplication of the database onto the dynamic memorization devices.
- analyses the contents of the database in order to determine the consistency and establish the operating status of the electronic measuring unit;
- processes the contents of the database in order to generate the "agenda" of the activities which the other algorithm agents will have to perform.

8. Electronic unit for measuring electric energy as claimed in Claim 1, wherein the "agenda" algorithm, upon receiving a request for variation of at least one programming operation contained in the database, processes the contents of the database in order to update the "agenda" of the activities which the other algorithm agents must perform.

9. Electronic unit for measuring electric energy as claimed in Claim 1, wherein the "agenda" algorithm agent manages the "in use" status of the information blocks forming together the database, so as to synchronize simultaneous updating operations, by more than one function algorithm agent, of the same block.

10. Electronic unit for measuring electric energy as claimed in Claim 2, wherein the "measurement" function algorithm agent performs the function of calculating the energy units detected by at least one sensor and effects incremental addition in a wait register managed by the "agenda" algorithm agent.

11. Electronic unit for measuring electric energy as claimed in Claim 10, wherein the "processing" function algorithm agent carries out a remote procedure of the "measurement" function agent in order to copy the value of said wait register into a processing register of the "agenda" algorithm agent and resets the contents of said wait register and carries out the tariff processing operations on the contents of the processing register.

12. Electronic unit for measuring electric energy as claimed in Claim 2, wherein the "communication" function algorithm agent manages communication between the measuring unit and the remote devices which dialogue with said measuring unit and transfers the messages received from the latter into the database of the measuring unit itself.

13. Electronic unit for measuring electric energy as claimed in Claim 1, comprising a loading software which is formed by at least one algorithm agent and intrinsically separated from the software of the algorithm agents, said loading software comprising the production testing procedures.

14. Electronic unit for measuring electric energy as claimed in Claim 2, comprising moreover a "diagnostics" algorithm agent, which signals at least which function algorithm agent has not been carried out.

15. Electronic unit for measuring energy as claimed in Claim 1, wherein management of the interruption in the power supply is performed by making use of a maskable interrupt.

16. Electronic unit for measuring electric energy as claimed in Claim 1, wherein each algorithm agent runs on its own microprocessor, separate from those of the other algorithm agents.

17. Electronic unit for measuring electric energy as claimed in Claim 1, wherein at least some of the algorithm agents run on a common microprocessor.

18. Electronic unit for measuring electric energy as claimed in Claim 1, wherein at least some of the algorithm agents consist of custom or semi-custom circuits.
